# EUROPÄISCHE PATENTSCHRIFT

(11) **EP 1 263 060 B1**
(45) Veröffentlichungstag und Bekanntmachung des Hinweises auf die Patenterteilung: **07.05.2008**
(21) Anmeldenummer: 02010012.9
(22) Anmeldetag: 04.05.2002
(51) Int. Cl.: H01L 41/24, H01L 41/09

(54) **Verfahren zur Herstellung eines flachen mehrschichtigen Biegewandlers sowie entsprechender Biegewandler**
Manufacturing method for a flat multilayer bending transducer and corresponding bending transducer
Méthode de fabrication d'un transducteur à flexion plat multicouche et transducteur correspondant

(30) Priorität: 11.05.2001 DE 10122944
(43) Veröffentlichungstag der Anmeldung: 04.12.2002
(73) Patentinhaber: CATERPILLAR INC., Peoria, Illinois 61629-6490 (US)
(72) Erfinder: Döllgast, Bernhard, 91054 Erlangen (DE); Schmauser, Till M., 90469 Nürnberg (DE)
(74) Vertreter: Wagner & Geyer

(56) Entgegenhaltungen:
- WO-A-03/003479
- DE-A- 2 035 629
- DE-A- 19 520 796
- DE-A- 19 732 513
- US-A- 5 103 361
- US-A- 5 632 841

## Beschreibung

Die Erfindung bezieht sich auf ein Verfahren zur Herstellung eines flachen mehrschichtigen asymetrischen Biegewandlers, mit mindestens einer passiven Trägerschicht und mit mindestens einer elektrisch aktivierbaren Materialschicht, vorzugsweise Piezokeramik, sowie mit einer Klebeschicht zwischen den Schichten. Sie bezieht sich weiter auf einen danach hergestellten mehrschichtigen Biegewandler zum Einsatz als Aktor oder Sensor.

Um bei einem derartigen Biegewandler infolge einer durch eine elektrische Ansteuerung des Biegewandlers hervorgerufenen Längenänderung der aktivierbaren Materialschicht eine Biegung aus der Ebene heraus zu bewirken, ist die aktivierbare Materialschicht grundsätzlich außerhalb der Mittelebene des Bauelementes angeordnet.

Aus der US 5,632,841 und aus der US 6,060,811 ist eine Anordnung bekannt, bei der durch unterschiedliche thermische Dehnung ein flacher Verbund aus einem Metall und einer aktiven Keramik, insbesondere einer Piezokeramik auf der Basis Blei-Zirkonat-Titanat, vorgespannt wird. Der Verbund wird bei hoher Temperatur gefügt, wobei nach dem Erstarren eines Polymers, das für die Verbindung eingesetzt wird, in der Keramik eine mechanische Spannung entsteht, so dass die Keramik unter Druck gesetzt wird.

Aus der US 5,471,721 ist ein als "Rainbow" bezeichneter Aktor bekannt, der durch partielle chemische Reduktion einen inneren Schichtaufbau aufweist, wobei die reduzierte Schicht die Funktion des Metalls bei anderen Konstruktionen erfüllt.

Der Vorteil dieser bekannten Konstruktionen ist, dass durch die thermische Vorspannung die Effektivität der Energieumwandlung in der Piezokeramik und der Widerstand gegen Brüche der Keramik gesteigert wird. Nachteilig bei dieser Konstruktion ist jedoch, dass durch die Unterschiede der thermischen Dehnung nicht nur bei der elektrischen Ansteuerung, sondern auch bei einer Änderung der Umgebungstemperatur eine Änderung der Form auftritt. Diese Änderung ist in der gleichen Größenordnung wie die Formänderung aufgrund der elektrischen Ansteuerung. Dadurch ist der Temperaturbereich, in dem die Wandler eingesetzt werden können, stark eingeschränkt.

DE 195 20 796 offenbart Biegewandler, bei denen der thermische Ausdehnungskoeffizent von Trägerschicht und Piezokeramik aneinander angepaßt sind.

Aus der DE 197 32 513 A1 ist eine Anordnung zum Schutz eines piezokeramischen Aktors durch Druckspannung bekannt. Dabei handelt es sich um ein flächiges, symmetrisches Element, bei dem die aktive Materialschicht zentral in der Symmetrieebene liegt, und das mit zwei mechanisch vorgespannten Platten verbunden ist. Durch diese symmetrische Anordnung mit der aktivierbaren Materialschicht als Mittellage wird eine Biegung infolge einer Ansteuerung des Aktors oder Bauelementes verhindert. Bei dieser Anordnung handelt es sich daher nicht um einen Biegewandler. Vielmehr erfolgt die Ausleitung der Nutzenergie in der Ebene des Bauelementes an dessen schmalen Stirnseiten.

Ein symmetrischer Wandler zeigt konstruktionsbedingt keine Änderung der Form mit einer Änderung der Temperatur. Dennoch ändern sich die mechanischen Eigenspannungen, so dass der Schutzeffekt durch die Druckspannung in der Keramik im Extremfall aufgehoben werden kann.

Der Erfindung liegt daher die Aufgabe zugrunde, ein besonders geeignetes Verfahren zur Herstellung eines temperaturstabilen flachen piezoelektrischen Biegewandlers oder Aktors anzugeben. Des Weiteren soll ein besonders geeigneter Aktor angegeben werden, bei dem die genannten Nachteile vermieden sind.

Bezüglich des Verfahrens wird diese Aufgabe erfindungsgemäß gelöst durch die Merkmale des Anspruchs 1. Vorteilhafte Weiterbildungen sind Gegenstand der Unteransprüche.

Bezüglich des Bauelementes wird die genannte Aufgabe erfindungsgemäß gelöst durch die Merkmale des Anspruchs 7.

Ein temperaturstabiles, flaches, mehrschichtiges Bauelement zum Einsatz als Aktor oder Sensor, umfaßt mindestens eine passive Trägerschicht und mindestens eine elektrisch aktivierbare Materialschicht, vorzugsweise Piezokeramik, sowie eine genügend steife Klebeschicht zwischen den Schichten. Indem das Trägermaterial zweckmäßigerweise den gleichen thermischen Wärmeausdehnungskoeffizienten wie die Piezokeramik im Temperatureinsatzspektrum auf weist, unterliegt das Trägermaterial keiner Temperaturabhängigkeit der Auslenkung bzw. der Kraft.

Das Trägermaterial steht vor und während dem Fügen in einer Thermopresse unter Zugspannung. Diese ist durch eine Zugkraft hervorgerufen, die parallel zur Hauptebene des Trägermaterials und bis mindestens zum Unterschreiten der Erweichungstemperatur bzw. Reaktionstemperatur des Klebesystems, d.h. bis zu dessen Aushärtung wirkt.

Beim Fügvorgang in der Thermopresse wird ein bestimmtes Druck-, Zugkraft- und Temperaturprofil über die Zeit durchfahren, wobei der Druck orthogonal und die Zugkraft parallel zur Hauptebene wirkt. Dadurch ergibt sich eine Dehnung (s) des Trägermaterials, die während des Fügvorgangs vorteilhafterweise erhalten bleibt und nach dem Fügvorgang die Druckspannung im Einsatz auf die Piezokeramik bildet sowie im Falle der asymmetrischen Bauweise je nach Größe die Wölbung bestimmt.

Im Falle der symmetrischen Bauweise tritt aus Symmetriegründen keine Wölbung auf. Allerdings wirkt eine um so größere Druckspannung auf die beidseitig aufgeklebte Keramik.

Die auf Zugspannung empfindliche Piezokeramik steht im Einsatz stets unter einer voreingestellten Druckspannung, die die Keramik vor Bruch oder Beschädigung durch die Zugspannung schützt. Die Keramik - wenn es sich um eine Piezokeramik handelt - wird nach dem Fügprozess durch Anlegen einer elektrischen Spannung polarisiert. Dabei wird der Polarisationsprozess durch die in der Keramik herrschende Druckspannung gefördert.

Durch diese Herstellungsmethode und diese Konstruktion eines piezoelektrischen Biegewandlers oder Aktors ist eine Möglichkeit gegeben, die Temperaturabhängigkeit der asymmetrischen Biegeelemente mit innerer mechanischer Vorspannung in besonders einfacher Art und Weise und somit wirtschaftlich zu eliminieren.

Die innere Vorspannung der Keramik wird durch die mechanische Vorspannung des metallischen Trägermaterials während des Fügprozess erzeugt. Das Trägermaterial und die Keramik haben idealer weise die gleichen thermischen Ausdehnungskoeffizienten, um im Einsatzbereich des Biegeelements keine Temperaturabhängigkeit der Auslenkung bzw. Kraft zu haben.

Nachfolgend wird ein Ausführungsbeispiel der Erfindung anhand einer Zeichnung näher erläutert. Darin zeigen:
- Fig. 1: in einer Diagrammdarstellung den Herstellungszyklus eines Biegewandlers mit mechanischer Vorspannung, und
- Fig. 2: schematisch die Druck- und Kraftverhältnisse beim Herstellungszyklus oder Fügeprozeß gemäß Fig. 1 sowie den Aufbau des Biegewandlers.

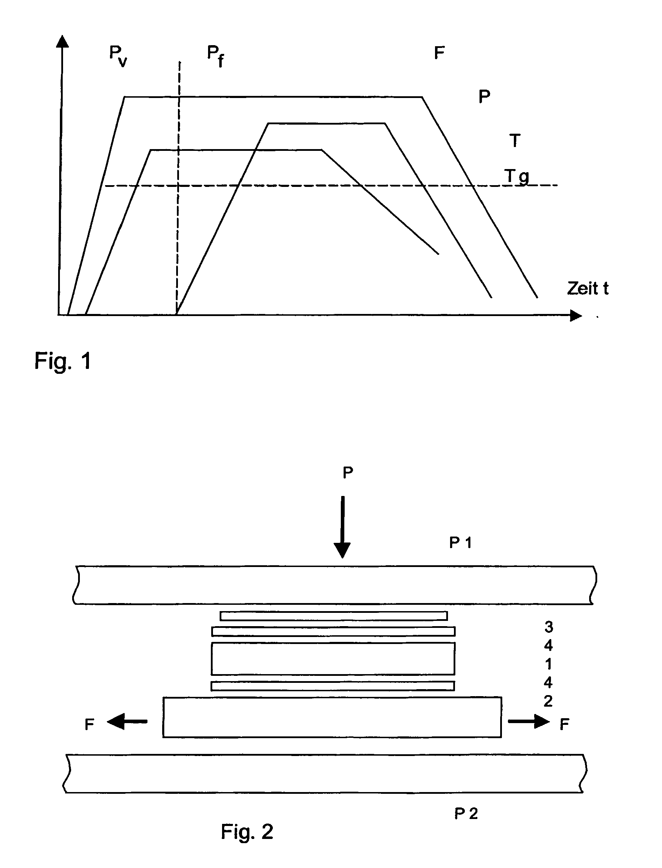

Bei der Verwendung eines thermoplastischen Materials als Kleber 4 wird ein mit dem Kleber 4 beschichtetes Trägermaterial 2 bis auf eine Temperatur nahe der Erweichungs- oder Reaktionstemperatur T_{g} des Klebers 4, z.B. Polyimid, erwärmt. Dabei wird auf das Trägermaterial 2 bereits mittels einer Zugkraft F eine Zugspannung ausgeübt. Dann wird eine Piezokeramik 1 als aktivierbare Materialschicht, die ebenfalls mit dem Kleber 4 beschichtet wurde, aufgelegt und leicht angedrückt. Eine weitere Lage, z.B. eine elektrisch leitende Folie 3, kann ebenfalls aufgelegt und leicht angedrückt werden. Ist der flächige Stapel fertig vormontiert, beginnt der eigentliche Fügevorgang in einer planen, aber mikrostrukturierten Thermopresse mit dem in Fig. 1 dargestellten Profil von Temperatur T, Zugkraft F und Druckkraft P über die Zeit t.

Eine hierzu vorgesehene Presse gemäß Fig. 2 umfasst zwei im Wesentlichen ebene und zueinander parallele Platten P1, P2. Vor der Druckbeaufschlagung mit dem Druck P wird das mit der Klebeschicht 4 beschichtete Trägermaterial 2 idealerweise bis maximal unter der Bruchdehnung oder Elastizitätsgrenze mechanisch gedehnt und gehalten.

Bei der Verwendung eines duroplastischen Klebers 4 erfolgt der Vorgang analog, wobei die mechanische Zugspannung während der chemischen Reaktion der Aushärtung angelegt und bis zum Unterschreiten der Erweichungstemperatur T_{g} des reagierten Klebersystems aufrechterhalten wird. Die geometrischen Verhältnisse der Zugkraft F und der Druckkraft P sind in Fig. 2 veranschaulicht.

Bei dem in Fig. 1 veranschaulichten zeitlichen Ablauf des Fügevorganges wird in einer ersten Phase oder Vorbereitungsphase Pᵥ durch Anlegen der Zugkraft F die Trägerschicht 2 gedehnt und auf die Verarbeitungstemperatur T erwärmt. Während einer darauf folgenden zweiten Phase oder Fügephase P_{f}, die den eigentlichen Fügeprozess darstellt, wird die Druckkraft P auf einen solchen Wert erhöht, dass durch plastische Deformation und Fließen des Klebers eine homogene Füllung der Klebefuge gewährleistet ist. Unter Beibehaltung der Druckkraft P und der Zugkraft F wird die Temperatur T auf einen Wert unterhalb der Erweichungs- oder Glasübergangstemperatur T_{g} des Klebers 4 abgesenkt. Unter Abbau der Druckkraft P wird die Presse P1, P2 geöffnet und der Fügeprozess ist beendet.

Nach dem Öffnen der Thermopresse und Abschaltung der Zugspannung stellt sich eine Biegung des asymmetrischen Biegeelementes gemäß den internen mechanischen Spannungsverhältnissen und den Widerstandsmomenten ein. Bei symmetrischen Wandlern stellt sich keine Biegung ein, da die internen mechanischen Druckspannungen in der Keramik in beiden Schichten symmetrisch auftreten und daher die Deformation zu Null ergänzt wird.

### Bezugszeichenliste

- 1: Materialschicht / Piezokeramik
- 2: Trägermaterial
- 3: Folie
- 4: Kleber

- F: Zugkraft
- P: Druckkraft
- P1,2: Platte
- P_{f}: Fügephase
- Pᵣ: Vorbereitungsphase
- T: Temperatur

## Patentansprüche

1. Verfahren zur Herstellung eines flachen mehrschichtigen asymmetrischen Biegewandlers, mit mindestens einer passiven Trägerschicht (2) und mit mindestens einer elektrisch aktivierbaren Materialschicht (1), vorzugsweise Piezokeramik, sowie mit einer Klebeschicht (4) zwischen den Schichten (1,2), wobei das Trägermaterial (2) den gleichen thermischen Wärmeausdehnungskoeffizienten wie die aktivierbare Materialschicht (1) im Temperatureinsatzspektrum aufweist, **dadurch gekennzeichnet, daß** das Trägermaterial (2) vor und während dem Fügen der Schichten (1,2,4) unter einer parallel zur Hauptebene des Trägermaterials (2) wirkenden Zugspannung (F) steht.

2. Verfahren nach Anspruch 1, bei dem eine die Zugspannung hervorrufende Zugkraft (F) bis mindestens zum Unterschreiten der Erweichungstemperatur (T_{g}) des Klebers (4) wirkt.

3. Verfahren nach Anspruch 1 oder 2, bei dem beim Fügvorgang (P_{f}), insbesondere in einer Thermopresse (P1 ,P2), ein bestimmtes Druck-, Zugkraft- und Temperaturprofil (P,F,T) über die Zeit (t) durchfahren wird derart, dass eine Dehnung des Trägermaterials (2) resultiert, die während des Fügvorgangs (P_{f}) erhalten bleibt und nach dem Fügvorgang (P_{f}) die Druckspannung im Einsatz auf die Piezokeramik (1) bildet, wobei der Druck (P) orthogonal und die Zugkraft (F) parallel zur Hauptebene des Trägermaterials (2) wirken.

4. Verfahren nach Anspruch 3, bei dem die resultierende Dehnung des Trägermaterials (2) im Falle einer asymmetrischen Bauweise eine von der Bauelementgröße abhängige Wölbung des Biegewandlers bestimmt.

5. Verfahren nach einem der Ansprüche 1 bis 4, bei dem die auf Zugspannung (F) empfindliche Piezokeramik (1) im Einsatz stets unter einer voreingestellten Druckspannung steht.

6. Verfahren nach einem der Ansprüche 1 bis 5, bei dem die elektrisch aktivierbare Materialschicht (1), insbesondere die Piezokeramik, nach dem Fügprozess (P_{f}) durch Anlegen einer elektrischen Spannung polarisiert wird.

7. Mehrschichtiger flacher asymmetrischer Biegewandler insbesondere piezoelektrischer Biegewandler zum Einsatz als Aktor oder Sensor, mit einer passiven Trägerschicht (2) und mit einer elektrisch aktivierbaren Materialschicht (1), vorzugsweise Piezokeramik, sowie mit einer Klebeschicht (4) zwischen den Schichten (1,2), wobei das Trägermaterial (2) den gleichen thermischen Wärmeausdehnungskoeffizienten wie die aktivierbare Materialschicht (1) im Temperatureinsatzspektrum aufweist, **dadurch gekennzeichnet, daß** der Biegewandler durch ein Verfahren nach einem der Ansprüche 1 bis 6 hergestellt wurde.

## Claims

1. A method of manufacturing a flat multilayer asymmetric bending transducer having at least one passive support layer (2) and at least one electrically activatable layer (1) of material preferably piezoceramic, as well as an adhesive layer (4) between those layers (1, 2);
wherein the support material (2) has the same thermal heat expansion coefficient as the activatable layer (1) of material in the used temperature spectrum,
**characterized in that**:
the support material (2) is subjected before and during the arrangement of the layers (1, 2, 4) to a tension (F) which acts parallel to the main plane of the support material (2).

2. The method of claim 1, wherein a tension or pulling force (F) creates the tension which acts at least until the temperature decreases below the softening temperature (T_{g}) of the adhesive (4).

3. The method of claim 1 or 2 for which, during the setting process (P_{f}), in particular in a thermo press (P1, P2) a certain pressure profile, a certain tension profile, and a certain temperature profile (P, F, T) is followed such, that an elongation of the support material (2) results, an elongation which is maintained during the forming process (P_{f}), said elongation creating said compression stress when used on the piezoceramic (1), wherein the pressure (P) acts orthogonally and the pulling force (F) acts in parallel to the main plane of the support material (2).

4. The method of claim 3, wherein the resulting elongation of the support material (2) in the case of an asymmetric design determines, depending on the size of the component, a bulge of the bending transducer.

5. The method according to one of claims 1 to 4, wherein the piezoceramic (1), which is sensitive to the tension force (F) is subjected in use to a predetermined compression stress.

6. The method according to one of claims 1 to 5, wherein the electrically activatable material layer (1), in particular the piezoceramic, is polarized after the formation process (P_{f}) by applying an electrical voltage.

7. A multi-layer flat asymmetric bending transducer, in particular a piezoelectric bending transducer for use as a transducer or a sensor having; a passive support layer (2) with an electrically activatable material layer (1), preferably a piezoceramic, and having an adhesive layer (4) between the layers (1, 2), wherein the support material (2) has the same thermal heat expansion coefficient as the activatable material layer (1) within the used spectrum of temperatures, **characterized in that**, the bending transducer is manufactured by a method as set forth in one of claims 1 to 6.

## Revendications

1. Procédé de fabrication d'un transducteur de flexion asymétrique plat à plusieurs couches comprenant au moins une couche de support passive (2) et au moins une couche de matériau activable électriquement (1), de préférence une céramique piézoélectrique, ainsi qu'une couche adhésive (4) entre les couches (1, 2), dans lequel le matériau de support (2) présente les mêmes coefficients de dilatation thermique que la couche de matériau activable (1) dans le spectre d'utilisation de la température, **caractérisé en ce que** le matériau de support (2) est soumis, avant et pendant l'assemblage des couches (1, 2, 4), à une contrainte de traction (F) agissant parallèlement au plan principal du matériau de support (2).

2. Procédé selon la revendication 1, dans lequel une force de traction (F) produisant la contrainte de traction agit jusqu'à ce que l'on passe au moins en dessous de la température de ramollissement (T_{g}) de l'adhésif (4).

3. Procédé selon la revendication 1 ou 2, dans lequel un certain profil de pression, de force de traction et de température (P, F, T) est parcouru sur l'intervalle de temps (t) lors de l'opération d'assemblage (P_{f}), en particulier dans une thermopresse (P1, P2), de manière à assurer une dilatation du matériau de support (2), qui est conservée pendant l'opération d'assemblage (P_{f}) et qui, après l'opération d'assemblage (P_{f}), forme la contrainte de compression exercée sur la céramique piézoélectrique (1), la pression (P) agissant orthogonalement et la force de traction (F) parallèlement au plan principal du matériau de support (2).

4. Procédé selon la revendication 3, dans lequel la dilatation obtenue du matériau de support (2) détermine, dans le cas d'un mode de construction asymétrique, une courbure du transducteur de flexion dépendant de la taille du composant.

5. Procédé selon l'une quelconque des revendications 1 à 4, dans lequel la céramique piézoélectrique (1) sensible à la contrainte de traction (F) subit toujours en service une contrainte de compression prédéfinie.

6. Procédé selon l'une quelconque des revendications 1 à 5, dans lequel la couche de matériau activable électriquement (1), en particulier la céramique piézoélectrique, est polarisée, après l'opération d'assemblage (P_{f}), par application d'une tension électrique.

7. Transducteur de flexion asymétrique plat à plusieurs couches, en particulier transducteur de flexion piézoélectrique, destiné à être utilisé comme actionneur ou capteur, comportant une couche de support passive (2) et une couche de matériau activable électriquement (1), de préférence une céramique piézoélectrique, ainsi qu'une couche adhésive (4) entre les couches (1, 2), dans lequel le matériau de support (2) présente les mêmes coefficients de dilatation thermique que la couche de matériau activable (1) dans le spectre d'utilisation de la température, **caractérisé en ce que** le transducteur de flexion est fabriqué par un procédé selon l'une quelconque des revendications 1 à 6.
